Europäisches Patentamt

European Patent Office

Office européen des brevets

(19)

(11) EP 0 579 537 B1

(12) **FASCICULE DE BREVET EUROPEEN**

(45) Date de publication et mention
de la délivrance du brevet:
**08.10.1997 Bulletin 1997/41**

(51) Int Cl.6: **G01R 33/26**

(21) Numéro de dépôt: **93401805.2**

(22) Date de dépôt: **12.07.1993**

(54) **Magnétomètre à polarisation lumineuse et à champ de radio-fréquence asservis**

Magnetometer mit polarisiertem Licht und gesteuertem Hochfrequenzfeld

Magnetometer with polarized light and servo-controlled radio frequency field

(84) Etats contractants désignés:
DE GB IT

(30) Priorité: **16.07.1992 FR 9208783**

(43) Date de publication de la demande:
**19.01.1994 Bulletin 1994/03**

(73) Titulaire: **COMMISSARIAT A L'ENERGIE ATOMIQUE**
**75015 Paris (FR)**

(72) Inventeurs:
• **Leger, Jean-Michel**
**F-38240 Meylan (FR)**
• **Crescini, Jean**
**F-38420 Domene (FR)**
• **Guttin, Christophe**
**F-38730 Virieu (FR)**

(74) Mandataire: **Signore, Robert et al**
**c/o BREVATOME**
**25, rue de Ponthieu**
**75008 Paris (FR)**

(56) Documents cités:
**EP-A- 0 288 927          EP-A- 0 461 999**
**US-A- 4 327 327**

• **OPTICS COMMUNICATIONS vol. 81, no. 6, 15 Mars 1991, AMSTERDAM NL pages 369 - 374 H. GILLES ET AL. "4He OPTICAL PUMPING WITH POLARIZATION MODULATED LIGHT"**
• **REVUE DE PHYSIQUE APPLIQUEE vol. 5, no. 1, 1 Février 1970, PARIS, FR pages 121 - 130 J.L. MEILLEROUX 'PROGRES RECENTS SUR LE MAGNETOMETRE A VAPEUR DE CESIUM TYPE "ASSERVI"'**

EP 0 579 537 B1

## Description

## Domaine technique

La présente invention a pour objet un magnétomètre à polarisation lumineuse et à champ radio-fréquence asservis. Elle trouve une application dans la mesure précise des champs magnétiques faibles (typiquement dans la plage de 20 à 70 µT qui correspond aux valeurs du champ magnétique terrestre).

## Etat de la technique antérieure

Le magnétomètre de l'invention entre dans la catégorie des magnétomètres dits à résonance, dont on pourra trouver une description générale dans l'article de F. HARTMAN intitulé "Resonance Magnetometers", publié dans la revue IEEE Transactions on Magnetics, vol. MAG-8, n° 1, mars 1972, pp. 66-75.

Un magnétomètre à résonance est un appareil qui, plongé dans un champ magnétique Bo, délivre un signal électrique de fréquence F dont la valeur est liée à Bo par la relation dite de LARMOR :

$$F = \gamma Bo,$$

où $\gamma$ est un rapport gyromagnétique d'un électron ou d'un nucléon, selon la substance utilisée. Pour l'électron, par exemple, ce rapport est égal à 28 Hz/nT.

L'excitation de la résonance magnétique est obtenue par un enroulement disposé autour de la substance utilisée. Le prélèvement du signal de résonance s'effectue soit par un autre enroulement (variante électrique) soit par un faisceau lumineux de pompage (variante optique).

L'invention qui va être décrite relève de la seconde variante.

Le document FR-A-2 663 430 décrit un magnétomètre à pompage optique qui est représenté schématiquement sur la figure 1.

Une cellule 10, au moins partiellement transparente, est remplie d'un gaz 12, en général de l'hélium, à une pression de 1 à quelques torrs. Une source lumineuse 14 délivre un faisceau lumineux 15 dont la longueur d'onde se situe autour de 1,1 µm. Ce faisceau traverse un polariseur rectiligne 16. Le faisceau polarisé 17 qui en résulte traverse la cellule 10 et émerge sous forme d'un faisceau 18.

Par ailleurs, une décharge radio-fréquence (dite "faible" ou "douce") est produite dans le gaz 12 par un générateur 30 relié à deux électrodes 32, 33 disposées autour de la cellule 10. Cette décharge produit des atomes dans un état métastable ($2^3S_1$ dans le cas de l'hélium). Le faisceau lumineux incident 17 "pompe" ces atomes à partir de l'état métastable et les amène dans un autre état excité ($2^3P$).

En présence d'un champ magnétique Bo, les niveaux d'énergie se séparent en sous-niveaux, dits de ZEEMAN. Une résonance entre de tels sous-niveaux peut être établie par un champ radio-fréquence.

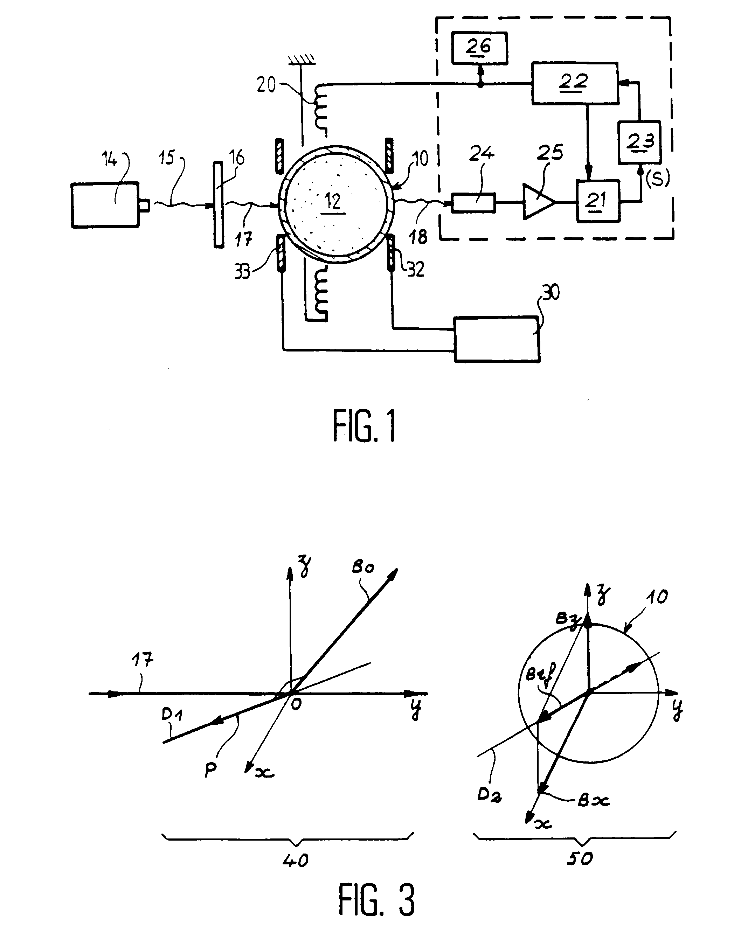

Cette résonance est mise en évidence par divers moyens connus de l'homme du métier, dont une variante est représentée sur la figure 1. Il s'agit d'un enroulement 20 disposé de part et d'autre de la cellule 10 (dans une disposition dite de HELMOLTZ), d'un générateur radio-fréquence 22, d'un photodétecteur 24 recevant le rayonnement lumineux émergent 18, d'un amplificateur 25 relié au photodétecteur 24, d'un détecteur synchrone 21 recevant un signal de référence provenant du générateur 22 et d'un intégrateur 23.

Le générateur 22 alimente l'enroulement 20 en courant à la fréquence F, ce qui crée un champ magnétique oscillant dont une composante entretient la résonance et module en retour le faisceau lumineux 18 ayant traversé la cellule 10. Cette modulation se retrouve dans le signal électrique délivré par le photodétecteur 24 et est détectée par le détecteur synchrone 21. Le signal délivré par le détecteur synchrone 21 possède une composante en phase avec le signal de référence, et cette composante sert de signal d'erreur. L'intégrateur 23 en élimine l'erreur statique. Ce signal d'erreur ajuste la fréquence F du générateur de fréquence 22 pour annuler le signal d'erreur. Ce générateur doit donc pouvoir être commandé en tension. Il peut s'agir par exemple d'un oscillateur commandé en tension (V.C.O. en abrégé pour "Voltage Controlled Oscillator").

Un signal électrique de résonance finit donc par s'établir dans cette boucle et ce signal est à la fréquence de LARMOR. Un fréquencemètre 26 en donne la valeur F. Le champ à mesurer Bo s'en déduit par la relation Bo = F/$\gamma$.

Les magnétomètres de ce type ont d'abord utilisé des lampes à hélium. L'obtention récente de cristaux d'aluminate de lanthane-néodyme (ou LNA) ayant permis de réaliser des lasers accordables autour de la longueur d'onde de 1,083 µm correspondant précisément à la raie de pompage optique de l'hélium, ce type de laser s'est substitué tout naturellement à ces lampes avec une amélioration sensible des performances, ce qui a donné un regain d'intérêt à ces magnétomètres.

Un tel magnétomètre, équipé d'un laser à LNA, est décrit dans le document FR-A-2 598 518.

Bien que satisfaisants à certains égards, ces magnétomètres présentent cependant des inconvénients. En effet, par principe, ils sont fortement anisotropes, et ceci à la fois en amplitude et en fréquence. Ces anisotropies sont soit des conséquences du cycle de pompage optique et de la détection de l'intensité lumineuse transmise, soit liées au phénomène de résonance optique.

Le document FR-A-2 663 430, déjà cité, propose une solution à ce problème. Elle consiste à munir le magnétomètre de moyens permettant de faire tourner la direction de polarisation rectiligne du faisceau lumineux 17 injecté dans la cellule 10, pour lui donner la direction optimale correspondant à une amplitude maximale du signal de résonance.

Plusieurs moyens peuvent être utilisés pour déterminer et obtenir cette direction optimale. Dans une première variante, le magnétomètre comprend un magnétomètre directionnel, comme par exemple un ensemble de trois "flux-gates" ou un magnétomètre à RPE (Résonance Paramagnétique Electronique), pour obtenir des informations sur la direction du champ ambiant à mesurer. Un circuit de traitement de ces informations calcule l'orientation optimale de la polarisation et commande, en conséquence, la rotation du polariseur.

Dans une deuxième variante, le magnétomètre comprend des moyens pour moduler à basse fréquence la direction de polarisation et pour effectuer une détection synchrone du signal de résonance. Le signal détecté sert de signal d'erreur pour corriger la polarisation et lui donner la direction optimale.

Bien que donnant satisfaction à certains égards, ces solutions présentent l'inconvénient de la complexité, surtout dans la variante à flux-gates associés. La variante à modulation de polarisation présente en outre l'inconvénient de réduire la bande passante du magnétomètre, puisque la fréquence maximale d'analyse est nécessairement inférieure à celle de la modulation.

**Exposé de l'invention**

La présente invention a justement pour but de remédier à ces inconvénients. A cette fin, elle prévoit un magnétomètre sans anisotropie (de fréquence ou d'amplitude) et qui ne fait pas appel à une modulation de la polarisation lumineuse ou à des magnétomètres directionnels associés. Ce résultat est obtenu en asservissant en direction la polarisation du faisceau lumineux incident dans une direction perpendiculaire au champ magnétique ambiant Bo à mesurer et, simultanément, en asservissant la direction du champ magnétique radiofréquence parallèlement à la direction de polarisation. En d'autres termes, la direction de polarisation ainsi que celle du champ radiofréquence se trouvent toutes deux orientées dans la même direction optimale et ce, quelle que soit la direction du champ magnétique à mesurer.

De façon précise, la présente invention a pour objet un magnétomètre à résonance et à pompage optique comprenant une cellule remplie d'un gaz dont les atomes présentent un rapport gyromagnétique γ, cette cellule plongeant dans un champ magnétique ambiant Bo qui est le champ à mesurer, une source lumineuse émettant un faisceau lumineux, un polariseur rectiligne traversé par ce faisceau et donnant à ce faisceau une polarisation rectiligne selon une première direction, le faisceau polarisé rectilignement traversant ensuite la cellule, un photodétecteur recevant le faisceau lumineux ayant traversé la cellule, ce photorécepteur délivrant un signal électrique, des moyens pour appliquer un champ radiofréquence à la cellule, ce champ ayant une seconde direction et une certaine fréquence, des moyens pour asservir cette fréquence à la fréquence de LARMOR F = γ Bo, un moyen pour mesurer cette fréquence, l'amplitude du champ magnétique ambiant Bo se déduisant de la fréquence F par la relation Bo = F/γ, ce magnétomètre étant caractérisé par le fait qu'il comprend en outre :

- des premiers moyens d'asservissement, agissant sur la première direction, qui est celle de la polarisation du faisceau lumineux, pour régler cette première direction à 90° de la direction du champ magnétique ambiant Bo, ces premiers moyens comprenant un premier circuit de détection synchrone recevant le signal électrique délivré par le photodétecteur et une tension de référence à la fréquence du signal radio-fréquence, ce circuit détectant l'amplitude de la composante en quadrature de phase avec le signal de référence, et vérifiant que l'amplitude du signal à la fréquence double de la fréquence de LARMOR n'est pas nulle, l'amplitude de ladite composante à la fréquence de LARMOR servant à commander des moyens pour faire tourner la direction de polarisation jusqu'à ce que cette amplitude soit nulle, la première direction se trouvant alors asservie perpendiculairement au champ magnétique ambiant,
- des seconds moyens d'asservissement agissant sur la seconde direction qui est celle du champ radiofréquence, pour faire coïncider cette seconde direction avec la première.

De préférence, les moyens pour commander la direction du champ radiofréquence comprennent deux enroulements d'axes orthogonaux et des moyens pour alimenter ces enroulements par deux courants ayant la même fréquence asservie à la fréquence de LARMOR et deux amplitudes convenablement pondérées.

Ces amplitudes pondérées peuvent être obtenues par un détecteur de position angulaire du polariseur.

**Brève description des dessins**

- la figure 1, déjà décrite, montre une magnétomètre selon l'art antérieur,
- la figure 2 illustre un magnétomètre selon l'invention,
- la figure 3 est un schéma montrant diverses directions impliquées dans l'invention,
- les figures 4a, 4b, 4c, 4d montrent les variations de l'amplitude de divers signaux en fonction de l'angle que fait la direction de polarisation avec le champ magnétique ambiant,
- la figure 5 montre deux enroulements à axes orthogonaux permettant d'obtenir le champ radiofréquence de direction appropriée,
- la figure 6 montre un mode de réalisation de moyens permettant de détecter l'angle de polarisation,

- la figure 7 montre un circuit pour la formation des deux courants d'alimentation des deux enroulements.

## Exposé détaillé d'un mode de réalisation

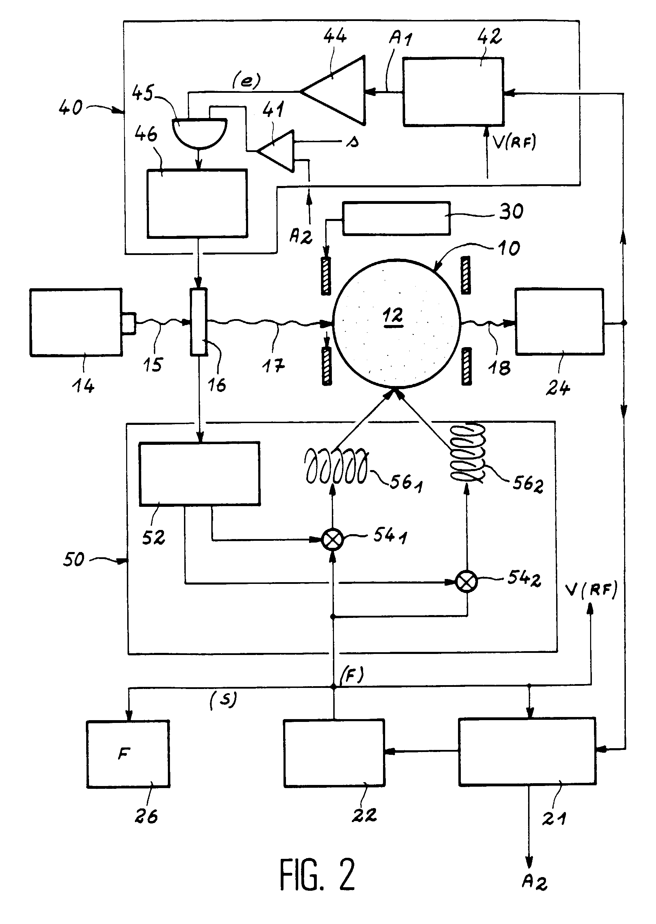

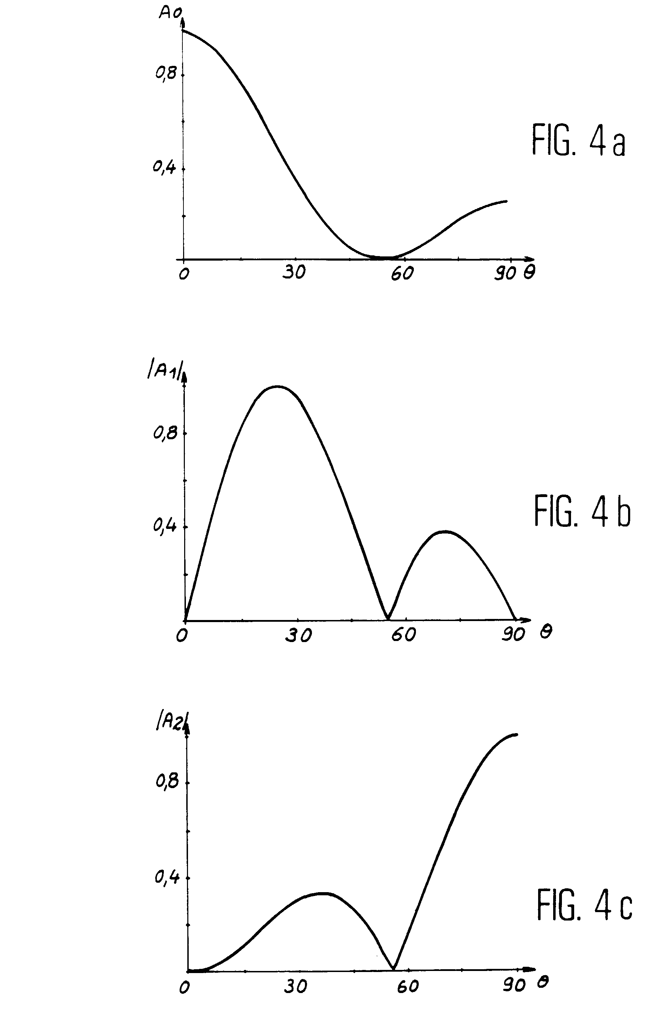

Le magnétomètre représenté sur la figure 2 comprend des moyens déjà représentés sur la figure 1 et qui portent pour cette raison les mêmes références. Il s'agit de la cellule 10 remplie de gaz 12, du laser 14 émettant un faisceau 15, du polariseur 16 délivrant un faisceau polarisé rectiligne 17, du photodétecteur 24 recevant le faisceau émergeant 18, du circuit d'asservissement de fréquence 21, du générateur de radiofréquence 22, du fréquencemètre 26 et du circuit de décharge 30. On observera que l'asservissement en fréquence du magnétomètre peut être obtenu indifféremment à partir d'un signal continu ou d'un signal à fréquence double de la fréquence de LARMOR, comme on le comprendra mieux en liaison avec les figures 4a à 4d.

Le magnétomètre représenté comprend en outre deux circuits d'asservissement de direction, le premier, référencé 40, agissant sur le polariseur 16 et le second, référencé 50, commandant la direction du champ radiofréquence.

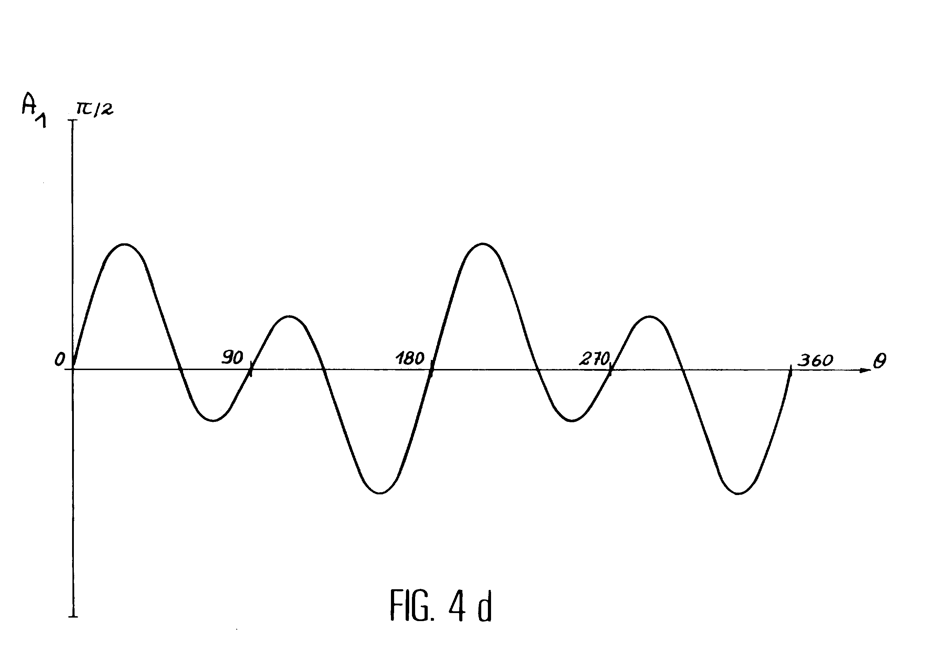

Le premier circuit d'asservissement 40 comprend un premier circuit de détection synchrone 42 recevant le signal électrique délivré par le photodétecteur 24 et une tension de référence $V_{RF}$ provenant du générateur 22. Ce circuit 42 détecte l'amplitude $A_1$ de la composante en quadrature de phase avec le signal de référence $V_{RF}$. Pour des raisons qui apparaîtront mieux en liaison avec la figure 4d, cette amplitude $A_1$ sert de signal d'erreur, lequel, une fois amplifié par un amplificateur 44, alimente un moteur 46 qui fait tourner le polariseur 16 dans un sens tel que le signal d'erreur s'annule.

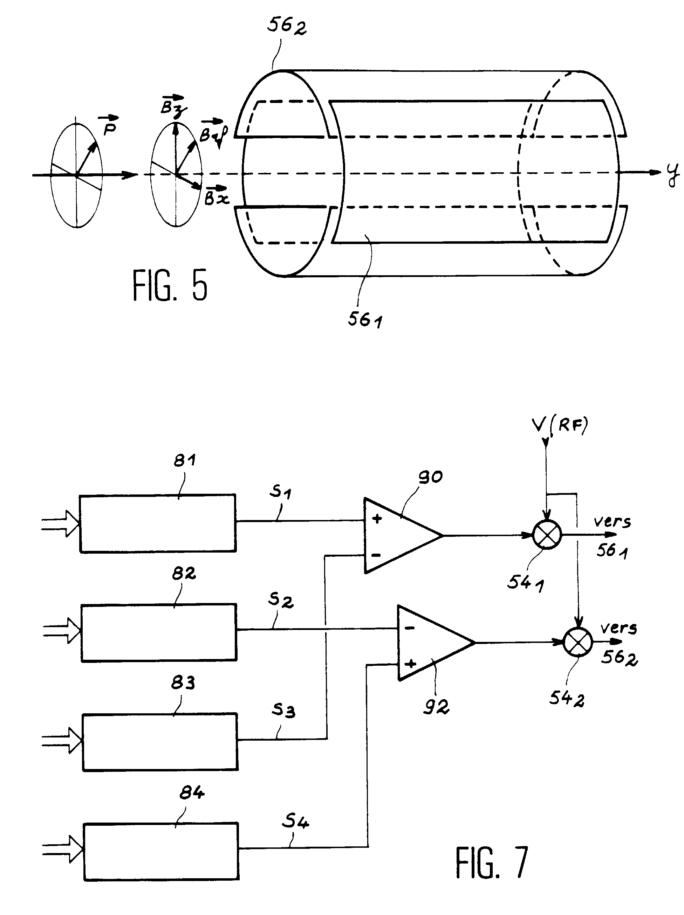

De son côté, le second circuit d'asservissement 50 comprennent un détecteur d'angle de polarisation 52, qui délivre deux signaux proportionnels à $\cos\theta$ et $\sin\theta$, si $\theta$ est l'angle dont on fait tourner la direction de polarisation du faisceau incident 17, deux multiplieurs $54_1$, $54_2$ recevant, d'une part, ces signaux et, d'autre part, le signal radiofréquence délivré par le générateur 22. Les sorties des deux multiplieurs sont connectées à deux enroulements $56_1$, $56_2$ à axes orthogonaux, comme il sera décrit plus bas en liaison avec la figure 5.

La figure 3 permet d'illustrer les fonctions remplies par les deux asservissements des moyens 40 et 50. Les directions sont repérées par rapport à un système d'axes trirectangle Oxyz. Le faisceau lumineux 17 est censé se propager le long de l'axe Oy. La polarisation rectiligne P de ce faisceau est donc située dans le plan xOz. Le champ magnétique ambiant Bo est dirigé dans une direction quelconque. Les moyens d'asservissement 40 ont alors pour fonction de donner à la polarisation P la direction $D_1$ perpendiculaire à Bo.

Quant au champ radiofréquence Brf dont la direction est notée $D_2$, il s'agit de l'orienter parallèlement à $D_1$. Pour cela, on donne aux deux composantes Bx et Bz de ce champ les valeurs appropriées, (la composante selon Oy étant nulle) pour que la composition de ces composantes donnent un champ ayant la direction $D_2$ souhaitée.

On observera que, quelle que soit la direction de Bo, il existe toujours une direction du plan xOz qui est perpendiculaire à Bo. Or il est certain qu'au cours d'une rotation complète du polariseur 16, la direction de polarisation P passera par une position à 90° de Bo. En effet, l'angle minimum que fait Bo avec une droite du plan xOz est égal à $(\pi/2)-\theta n$ si $\theta n$ désigne l'angle que fait la normale au plan xOz (autrement dit l'axe Oy) avec le champ Bo ; l'angle maximum est égal $(\pi/2)+ n$. Lors d'une rotation de 36° du polariseur, l'angle que fait la direction de polarisation P avec Bo variera donc entre $(\pi/2)-\theta n$ et $(\pi/2)+\theta n$. Il passera donc forcément par $\pi/2$.

Les figures 4a à 4d montrent les variations de certains signaux en fonction de l'angle $\theta$ que fait la direction de polarisation avec la direction du champ magnétique à mesurer Bo. Sur la figure 4a, l'amplitude $A_o$ est l'amplitude de la composante continue du signal. Cette composante est en $(3\cos^2\theta-1)^2$. Cette composante est nulle pour un angle d'environ 54°. Elle est maximum pour $\theta=90°$ et 0° (si $\theta=90°$ peut toujours être atteint, comme expliqué plus haut, ce n'est pas toujours le cas pour la valeur O qui ne peut être atteinte que si Bo est dans le plan xOz).

La figure 4b montre la valeur absolue $|A_1|$ de l'amplitude de la composante à la fréquence de LARMOR et en quadrature de phase avec le signal de radiofréquence. Cette composante est en $|\sin2\theta\ (3\cos^2\theta-1)|$. Elle s'annule pour $\theta=0$ et 90° et également pour 54°.

La figure 4c montre la valeur absolue de l'amplitude $A_2$ de la composante à la fréquence double de la fréquence de LARMOR. Cette composante est en $\sin^2\theta|$ $(1-3\cos^2\theta)|$. Elle s'annule pour $\theta=0$ et 54° et passe par un maximum pour $\theta=90°$.

Enfin, la figure 4d montre l'amplitude $A_1$, en grandeur et en signe, qui est le signal d'asservissement.

On voit que le signal $A_1$ à la fréquence de LARMOR, par son annulation et son changement de signe pour $\theta=90°$, constitue un signal d'erreur commode permettant d'obtenir un asservissement de la direction de polarisation à 90° du champ Bo. Mais ce signal s'annule également pour les angles 0 et 54° de sorte qu'il y a un risque de voir la direction de polarisation s'accrocher sur ces valeurs intempestives. Pour éviter ce risque, on utilisera conjointement le fait que le signal à fréquence double (fig. 4c) présente un maximum pour $\theta=90°$, ce qui permet de distinguer cette valeur des deux autres (0 et 54°) où $A_2$ est nul. Il n'est d'ailleurs pas nécessaire de s'assurer que le signal $A_2$ est maximum. Il suffit de vérifier qu'il n'est pas nul, c'est-à-dire, en pratique, qu'il excède un certain seuil.

L'asservissement de polarisation s'effectue donc en vérifiant que deux conditions sont simultanément satisfaites, à savoir que $A_1$ nul et $A_2$ supérieur à un certain seuil. Cette double fonction est assurée dans le circuit 40, par exemple par un comparateur 41 qui compare $A_2$ à un seuil s et à une porte logique ET 45 qui ne délivre un signal de commande du moteur 46 que si $A_2$ est supérieur au seuil.

Cette propriété du signal à la fréquence double peut n'être exploité qu'à la mise en route du magnétomètre pour accrocher la polarisation P à la valeur 90°. Ensuite, si le champ Bo change de direction, la polarisation restera asservie à la bonne direction.

Dès lors qu'il est fait usage du signal à fréquence double, il est avantageux d'exploiter ce même signal pour asservir en fréquence le magnétomètre et cela par les moyens 21 qui viennent piloter le générateur 22. Ce circuit 21 peut délivrer un signal reflétant l'amplitude $A_2$ de la composante à la fréquence double, à destination du comparateur 41 qui exploitera cette information pour valider le signal d'erreur $A_1$.

Le fait d'utiliser une détection sensible à la phase rend évidemment le système également dépendant de tous les phénomènes autres que la direction relative de la polarisation P par rapport au champ Bo et qui ont une incidence sur le déphasage du signal de résonance. Or, en résonance magnétique, un déphasage supplémentaire $\Delta\varphi_\varphi$ du signal optique de résonance par rapport au signal RF d'excitation peut apparaître dès que l'orientation du polariseur varie par rapport à celle du champ de radiofréquence. Dans le cas le plus défavorable, une variation $\Delta\varphi$ de l'orientation du polariseur se traduit par un déphasage supplémentaire du signal de résonance. On conçoit alors aisément que s'il existe une configuration pour laquelle le déphasage $\Delta\varphi_\varphi$ est égal à $\pi/2$ (à $\pi$ près), la sortie de la détection synchrone s'annulera également. On dispose alors également, autour de cette direction, d'un signal s'annulant et changeant de signe, de sorte que l'asservissement est également susceptible de s'accrocher sur ce point de fonctionnement, indépendamment de la valeur de $\theta_F$ pour cette configuration.

Pour s'affranchir de cette difficulté, il convient donc de s'assurer qu'en aucun cas une configuration quelconque ne permette d'obtenir un déphasage $\Delta\varphi_\varphi$ égal à $\pi/2$ (à $\pi$ près). Pratiquement, on asservit la direction du champ radiofréquence de manière que ce champ B1 soit toujours parallèle à P. On obtient alors des angles, par rapport à Bo, qui sont tous deux égaux à $\pi/2$ et de plus, le déphasage $\Delta\varphi_\varphi$ est constant (lié aux longueurs de câble par exemple) de sorte qu'il peut être choisi voisin de $\Delta\varphi_\varphi=O$. On fonctionne alors dans les conditions optimales pour le mode de détection de la résonance choisi.

Pour réaliser pratiquement un champ oscillant ayant une direction donnée dans le plan perpendiculaire à la direction de propagation du faisceau lumineux, on dispose autour de la cellule deux jeux de bobines d'axes orthogonaux comme représenté sur la figure 5 sous les

références $56_1$ et $56_2$. La bobine 561 a son axe parallèle à l'axe Ox et crée une composante Bx et la bobine $56_2$ a son axe parallèle à Oz et crée une composante Bz.

Il suffit alors de commander les courants parcourant chacune de ces bobines pour obtenir un champ RF d'amplitude et de direction voulues. En supposant que les fonctions de transfert courant/champ sont identiques pour les bobines $56_1$ et $56_2$ parcourues respectivement par des courants $i_1$ et $i_2$, la direction du champ oscillant $B_{rf}$ fera un angle $\theta =$ Arctg $i_2/i_1$ avec l'axe de la bobine $56_1$ et aura la même amplitude que celle qui serait créée par une bobine disposée suivant cette direction et parcourue par un courant $i= \sqrt{i_1^2+i_2^2}$. Dans l'invention, on souhaite créer un champ d'amplitude constante et de direction variable. Il suffit pour cela d'injecter des courants pondérés par $\cos\theta$ et $\sin\theta$, soit respectivement $i_1=i\cos\theta$ et $i_2=i\sin\theta$, l'angle $\theta$ étant repéré par rapport à l'axe de la bobine $56_1$ (axe Ox).

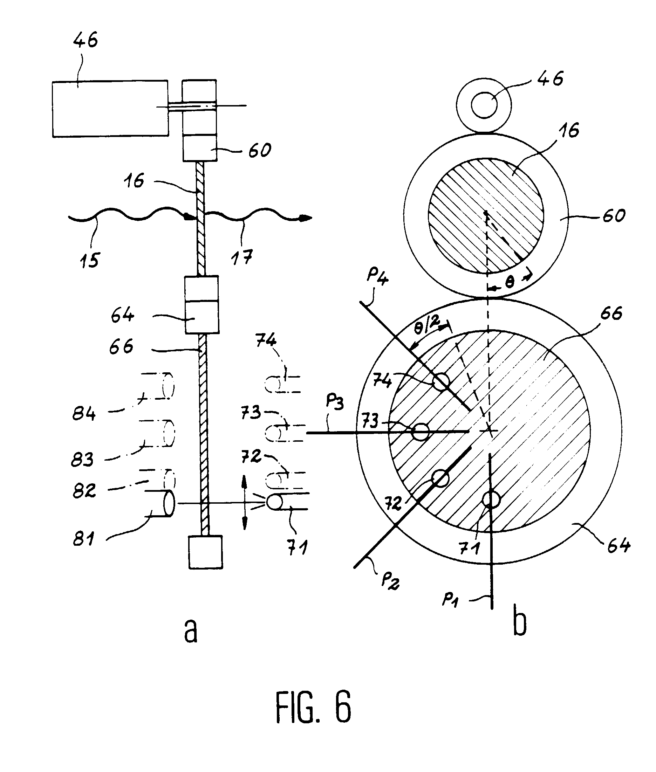

Un mode de réalisation de ces moyens est représenté sur les figures 6 et 7.

Sur la figure 6, on voit tout d'abord (en vue de côté <u>a</u> et en vue de face <u>b</u>) le polariseur 16 fixé sur une couronne 62 commandée en rotation par un moteur 46.

On voit en outre un second polariseur rectiligne 66 fixé sur une couronne 64 qui engrène sur la couronne 60. Le diamètre de ces couronnes est dans un rapport 2 de sorte que lorsque le polariseur 16 tourne d'un angle $\theta$, le polariseur 66 tourne d'un angle moitié $\pi/2$. Le dispositif représenté comprend encore quatre sources lumineuses 71, 72, 73, 74, par exemple des diodes électroluminescentes, associées respectivement à quatre photodétecteurs 81, 82, 83, 84 à travers le second polariseur 66. Ces quatre sources 71, 72, 73, 74 sont polarisées rectilignement à 45° les unes par rapport aux autres selon les directions P1, P2, P3, P4.

Des moyens sont prévus pour faire la différence entre deux signaux délivrés par deux photodétecteurs polarisés à 90° les uns des autres 81, 83 et 82, 84.

Ces moyens sont illustrés sur la figure 7 sous forme de deux soustracteurs 90, 92 reliés respectivement aux photodétecteurs 81, 83 et 82, 84.

Si l'on désigne par Sn le signal délivré par un photodétecteur de rang n (n=1 pour 81, n=2 pour 82, etc...) et par $\theta'$ l'angle de rotation du polariseur 66, on a :

$$Sn = I \cos^2 (\theta' + n(\pi/4)$$

soit

$$Sn = I/2 \; 1 + \sin(2\theta' + n(\pi/2)$$

comme l'angle $\theta'$ est égal à la moitié de $\theta$, par construction, on a $2\theta'=\theta$. Si l'on effectue la différence entre les signaux délivrés par les photodétecteurs 81, 83 d'une part, et 82, 84 d'autre part, on trouve, en sortie des soustracteurs 90 et 92, deux signaux égaux à :

$$S_1 - S_3 = I/2 \, (\cos\theta - \cos(\theta+\pi) \text{ soit I } \cos\theta$$

$$S_4 - S_2 = I/2 \, (\sin\theta - \sin(\theta+\pi) \text{ soit I } \sin\theta.$$

Ces courants vont servir à pondérer le signal radiofréquence $V_{RF}$ appliqué sur les multiplieurs $54_1$ et $54_2$ pour obtenir des courants d'excitation appropriés pour les enroulements $56_1$ et $56_2$. Se trouve, ainsi réalisé un dispositif créant un champ RF d'amplitude donnée et de direction asservie à celle du polariseur 16 celui-ci étant par ailleurs asservi de telle sorte que quelle que soit l'orientation du capteur par rapport au champ magnétique statique Bo, l'angle de la direction de polarisation avec Bo soit égal à $\pi/2$ (à $\pi$ près). Le magnétomètre fonctionne donc toujours dans sa configuration optimale.

## Revendications

1. Magnétomètre à résonance et à pompage optique comprenant une cellule (10) remplie d'un gaz (12) dont les atomes présentent un rapport gyromagnétique $\gamma$, cette cellule plongeant dans un champ magnétique ambiant Bo qui est le champ à mesurer, une source lumineuse (14) émettant un faisceau lumineux (15), un polariseur rectiligne (16) traversé par ce faisceau (15) et donnant à ce faisceau une polarisation rectiligne selon une première direction ($D_1$), le faisceau polarisé rectilignement (17) traversant ensuite la cellule (10), un photodétecteur (24) recevant le faisceau lumineux (18) ayant traversé la cellule (10), ce photorécepteur (24) délivrant un signal électrique, des moyens (20, 22) pour appliquer un champ radio-fréquence ($B_{rf}$) à la cellule (10), ce champ ayant une seconde direction ($D_2$) et une certaine fréquence, des moyens (21, 22, 23) pour asservir cette fréquence à la fréquence de LARMOR $F=\gamma Bo$, un moyen (26) pour mesurer cette fréquence (F), l'amplitude du champ magnétique ambiant Bo se déduisant de la fréquence F par la relation $Bo=F/\gamma$
ce magnétomètre étant caractérisé par le fait qu'il comprend en outre :

- des premiers moyens d'asservissement (40), agissant sur la première direction ($D_1$), qui est celle de la polarisation du faisceau lumineux pour régler cette première direction à 90° de la direction du champ magnétique ambiant Bo, ces premiers moyens (40) comprenant un premier circuit de détection synchrone (42) recevant le signal électrique délivré par le photodétecteur (24) et une tension de référence ($V_{RF}$) à la fréquence du signal radiofréquence, ce circuit (42) détectant l'amplitude ($A_1$) de la composante en quadrature de phase avec le signal de référence ($V_{RF}$), et vérifiant que l'amplitude ($A_2$) du signal à la fréquence double de la fréquence de LARMOR n'est pas nulle, l'amplitude de ($A_1$) de ladite composante à la fréquence de LARMOR (F) servant à commander des moyens pour faire tourner le polariseur (16) pour faire tourner la direction de polarisation ($D_1$) jusqu'à ce que cette amplitude soit nulle, la première direction se trouvant alors asservie perpendiculairement au champ magnétique ambiant (Bo),
- des seconds moyens d'asservissement (50) agissant sur la seconde direction ($D_2$), qui est celle du champ radiofréquence ($B_{rf}$), pour faire coïncider cette seconde direction ($D_2$) avec la première ($D_1$).

2. Magnétomètre selon la revendication 1, caractérisé par le fait que les moyens pour commander la direction ($D_2$) du champ radiofréquence ($B_{rf}$) comprennent deux enroulements ($56_1$, $56_2$) d'axes orthogonaux et des moyens (52, $54_1$, $54_2$) pour alimenter ces enroulements par deux courants ayant la même fréquence asservie à la fréquence de LARMOR et deux amplitudes pondérées.

3. Magnétomètre selon la revendication 2, caractérisé par le fait que les courants aux amplitudes pondérées sont obtenus par un détecteur (52) de la position angulaire du polariseur (16).

4. Magnétomètre selon la revendication 3, caractérisé par le fait que le détecteur de position angulaire (52) comprend un second polariseur rectiligne (66) commandé par des moyens pour le faire tourner d'un angle ($\theta/2$) moitié de l'angle de rotation ($\theta$) du premier polariseur (16), quatre sources lumineuses (71, 72, 73, 74) associées respectivement à quatre photodétecteurs (81, 82, 83, 84) à travers le second polariseur (66), ces quatre sources (71, 72, 73, 74) étant polarisées rectilignement à 45° les unes par rapport aux autres (P1, P2, P3, P4), des moyens (90, 92) pour faire la différence entre deux signaux délivrés par deux photodétecteurs polarisés à 90° les uns des autres (81, 83) (82, 84), ce qui donne les deux amplitudes nécessaires à la pondération des courants d'alimentation des deux enroulements ($56_1$, $56_2$).

## Patentansprüche

1. Optisch gepumptes Resonanzmagnetometer, umfassend eine Zelle (10), gefüllt mit einem Gas (12), dessen Atome ein gyromagnetisches Verhältnis $\gamma$ aufweisen, wobei diese Zelle eintaucht in ein Umgebungsmagnetfeld Bo, welches das zu messende Feld ist, eine ein Lichtbündel (15) aussende Lichtquelle (14), einen Linearpolarisator (16), durchquert von diesem Bündel (15), der diesem Bündel eine Linearpolarisation in einer ersten Richtung ($D_1$) verleiht, wobei das linear polarisierte Bündel (17) anschließend die Zelle (10) durchquert, einen Photodetektor (24), der das Lichtbündel (18) nach Durchquerung der Zelle (10) empfängt, wobei dieser Photorezeptor (24) ein elektrisches Signal liefert, Einrichtungen (20, 22) zum Anwenden eines Hochfrequenzfeldes ($B_{rf}$) auf die Zelle (10), wobei dieses Feld eine zweite Richtung ($D_2$) und eine bestimmte Frequenz hat, Einrichtungen (21, 22, 23) um diese Frequenz auf die LARMOR-Frequenz F=γ Bo zu regeln, eine Einrichtung (26) zum Messen dieser Frequenz (F), wobei die Amplitude bzw. Stärke des Umgebungsmagnetfelds Bo sich durch die Relation Bo=F/γ von der Frequenz F ableitet, **dadurch gekennzeichnet**, daß es außerdem umfaßt:

- erste Regeleinrichtungen (40), auf die erste Richtung ($D_1$) einwirkend, die diejenige der Polaristation des Lichtbündels ist, um diese erste Richtung auf 90° zur Richtung des Umgebungsmagnetfelds Bo zu regeln, wobei diese ersten Einrichtungen (40) eine erste Synchrondetektionsschaltung (42) umfassen, die das durch den Photodetektor (24) gelieferte elektrische Signal und eine Bezugsspannung ($V_{RF}$) mit der Frequenz des Hochfrequenzsignals empfängt, diese Schaltung (42) die Amplitude ($A_1$) der 90°-Phasenverschiebung mit dem Bezugssignal ($V_{RF}$) detektiert, und verifiziert, daß die Amplitude ($A_2$) des Signals mit der doppelten Frequenz der LAMOR-Frequenz (F) nicht null ist, die Amplitude ($A_1$) der besagten Komponente zu der LAMOR-Frequenz (F) dem Steuern der Einrichtungen zum Drehen des Polarisators (16) dienen, um die Polarisationsrichtung ($D_1$) zu drehen, bis diese Amplitude null ist, die erste Richtung dann senkrecht zum Umgebungsmagnetfeld Bo geregelt wird,
- zweite Regeleinrichtungen (50), auf die zweite Richtung ($D_2$) einwirkend, die diejenige des Hochfrequenzfeldes ($B_{rf}$) ist, um diese zweite Richtung ($D_2$) mit der ersten ($D_1$) in Übereinstimmung zu bringen.

2. Magnetometer nach Anspruch 1, dadurch gekennzeichnet, daß die Einrichtungen zum Steuern der Richtung ($D_2$) des Hochfrequenzfeldes ($B_{rf}$) zwei Wicklungen ($56_1$, $56_2$) mit rechtwinkligen Achsen umfassen und Einrichtungen (52, $54_1$, $54_2$) zum Versorgen dieser Wicklungen mit zwei Strömen, die dieselbe Frequenz haben, geregelt auf die LARMOR-Frequenz, und zwei bewertete bzw. gewichtete Amplituden bzw. Stärken.

3. Magnetometer nach Anspruch 2, dadurch gekennzeichnet, daß die Ströme mit den gewichteten Amplituden bzw. Stärken von einem Detektor (52) der Winkelstellung des Polarisators (16) kommen.

4. Magnetometer nach Anspruch 3, dadurch gekennzeichnet, daß der Winkelstellungsdetektor (52) einen zweiten Linearpolarisator (66) umfaßt, gesteuert durch Einrichtungen, um ihn um einen Winkel (θ/2) zu drehen, der Hälfte des Drehwinkels (e) des ersten Polarisators (16), sowie vier Lichtquellen (71, 72, 73, 74), jeweils verbunden mit vier Photodetektoren (81, 82, 83, 84) durch den zweiten Polarisator (66), wobei diese vier Quellen (71, 72, 73, 74) linear polarisiert werden, um jeweils 45° zueinander (P1, P2, P3, P4), sowie Einrichtungen (90, 92) zum Ermitteln der Differenz zwischen zwei durch zwei Photodetektoren gelieferten um 90° zueinander polarisierten Signalen (81, 83) (82, 84), was die beiden zur Bewertung bzw. Gewichtung der Versorgungsströme der beiden Wicklungen ($56_1$, $56_2$) nötigen Amplituden bzw. Stärken liefert.

## Claims

1. Optical pumping and resonance magnetometer incorporating a cell (10) filled with a gas (12), whose atoms have a gyromagnetic ratio ($\gamma$), said cell being immersed in an ambient magnetic field Bo, which is the field to be measured, a light source (14) emitting a light beam (15), a linear polarizer (16) traversed by said beam (15) and giving said beam a linear polarization in accordance with a first direction ($D_1$), the linearly polarized beam (17) then traversing the cell (10), a photodetector (24) receiving the light beam (18) which has traversed the cell (10), said photoreceiver (24) supplying an electric signal, means (20, 22) for applying a radio frequency field ($B_{rf}$) to said cell (10), said field having a second direction ($D_2$) and a certain frequency, means (21, 22, 23) for making this frequency dependent on the LARMOT frequency F = γBo, a means (26) for measuring said frequency (F), the amplitude of the ambient magnetic field Bo being deducted from the frequency F by the relation Bo = F/γ, said magnetometer being characterized in that it also comprises first slaving means (40) acting on the first direction ($D_1$), which is that of the polarization of the light beam, in order to regulate said first direction to 90° of the direction of the ambient magnetic field Bo, said first means (40) incorporating a first synchronous detection circuit (42) receiving the electric signal supplied by the photodetector (24) and a reference ($V_{RF}$) voltage at the frequency F of the radio frequency signal, said circuit (42) detecting the amplitude ($A_1$) of the phase quadrature component with the reference signal ($V_{RF}$), and verifying that

the amplitude ($A_2$) of the signal at double the Larmor frequency is not zero, the amplitude ($A_1$) of said component at the Larmor frequency (F) being used for controlling means for rotating the polarizer (16) in order to rotate the polarization direction ($D_1$) until said amplitude is zero, the first direction then being slaved perpendicular to the ambient magnetic field (Bo) and second slaving means (50) acting on the second direction ($D_2$), which is that of the radio frequency field ($B_{rf}$) in order to make said second direction (D2) coincide with the first ($D_1$).

2. Magnetometer according to claim 1, characterized in that the means for controlling the direction ($D_2$) of the radio frequency field ($B_{rf}$) incorporate two windings ($56_1$, $56_2$) having orthogonal axes and means ($52$, $54_1$, $54_2$) for supplying these windings by two currents having the same frequency dependent on the LARMOR frequency and two weighted amplitudes.

3. Magnetometer according to claim 2, characterized in that the currents at the weighted amplitudes are obtained by a detector (52) of the angular position of the polarizer (16).

4. Magnetometer according to claim 3, characterized in that the angular position detector (52) comprises a second linear polarizer (66) controlled by means for making it rotate by an angle ($\theta/2$) half the rotation angle ($\theta$) of the first polarizer (16), four light sources (71, 72, 73, 74) respectively associated with four photodetectors (81, 82, 83, 84) across the second polarizer (66), said four sources (71, 72, 73, 74) being polarized linearly at 45° of one another (P1, P2, P3, P4), means (90, 92) for forming the difference between two signals supplied by two photodetectors polarized at 90° of one another (81, 83; 82, 84), which gives the two amplitudes necessary for the weighting of the supply currents of the two windings ($56_1$, $56_2$).

FIG. 1

FIG. 3

FIG. 2

FIG. 4 a

FIG. 4 b

FIG. 4 c

FIG. 4 d

FIG. 5

V(RF)

FIG. 7

FIG. 6